# EUROPÄISCHE PATENTANMELDUNG

(11) **EP 4 822 749 A1**
(43) Veröffentlichungstag der Anmeldung: **14.10.2026**
(21) Anmeldenummer: 25170075.3
(22) Anmeldetag: 11.04.2025
(51) Int. Cl.: H01M 4/04, G01R 31/389, H01M 4/139, H01M 10/058

(54) **VERFAHREN UND VORRICHTUNG ZUR FORMIERUNG EINER BATTERIEZELLE**

(71) Anmelder: Siemens Aktiengesellschaft, 80333 München (DE)
(72) Erfinder: Fischer, Michael, 91320 Ebermannstadt (DE); Radinger, Hannes, 86152 Augsburg (DE); Schulte, Sascha, 91315 Höchstadt (DE)
(74) Vertreter: Siemens Patent Attorneys

(57) **Zusammenfassung**

Die Erfindung betrifft ein Verfahren (100) zur Formierung einer Batteriezelle, wobei die Batteriezelle während eines Formierungsprozesses für wenigstens einen Zeitbereich mit einer eingestellten Stromstärke beaufschlagt wird. Das Verfahren ist durch die folgenden Schritte gekennzeichnet:
- (102) Erfassen eines frequenzabhängigen Impedanzspektrums Z(ω) der Batteriezelle vor oder während des Formierungsprozesses; und
- (104) Einstellen der Stromstärke in Abhängigkeit von dem erfassten Impedanzspektrum Z(ω).

Weiterhin betrifft die Erfindung ein Herstellungsverfahren für wenigstens eine Batteriezelle und eine Vorrichtung zur Formierung einer Batteriezelle.

## Beschreibung

Die vorliegende Erfindung bezieht sich auf die Formierung von Batteriezellen und insbesondere auf die Optimierung eines Formierungsprozesses unter Verwendung von Impedanzmessungen, einschließlich eines Verfahrens zur Formierung einer Batteriezelle gemäß Anspruch 1, eines Herstellungsverfahrens für wenigstens eine Batteriezelle gemäß Anspruch 10 und einer Vorrichtung zur Formierung einer Batteriezelle gemäß Anspruch 13.

Für eine Batterieherstellung ist eine Formierung der Batteriezellen beziehungsweise der Batterien entscheidend für die Leistung und Lebensdauer der hergestellten Batterien. Eine Formierung wird insbesondere für Lithium-Ionen-Batterien und verwandten Chemien durchgeführt. Die Formierung beziehungsweise der Formierungsprozess, der typischerweise unmittelbar nach einem Befüllen der Batteriezelle mit Elektrolyt erfolgt, umfasst erste Lade- und Entladezyklen, die zu einer Ausbildung einer gewünschten Feststoff-Elektrolyt-Grenzphase (SEl-Schicht) auf der Oberfläche der negativen Elektrode der Batterie führen.

Die SEI-Schicht ist eine wichtige Komponente der Batterie. Sie dient als elektrisch isolierende, jedoch ionisch leitfähige Barriere zwischen der Elektrode und dem Elektrolyt. Ihre Ausbildung ist besonders für Lithium-Ionen-Batterien und Natrium-Ionen-Batterien wichtig, bei denen eine verbesserte SEI zu einer verbesserten und gegebenenfalls zu einer optimalen Batterieleistung führt. Die SEI-Schicht bildet sich durch elektrochemische Reaktionen zwischen den Elektrolytkomponenten und der Elektrodenoberfläche, die während des Formierungsprozesses innerhalb ermittelter Spannungs- und Temperaturbereiche ablaufen.

Die Formierung beziehungsweise Batterieformierung ist einer der zeitaufwändigsten und energieintensivsten Prozesse in der Batterieproduktion. Sie umfasst typischerweise mehrere Lade- und Entladezyklen, wobei typischerweise jeder Hersteller sein eigenes Formierungsprotokoll verwendet. Die genannten Protokolle umfassen spezifische Zyklusregimen und Ruheperioden, die sorgfältig entwickelt wurden, um die Ausbildung der SEI-Schicht zu optimieren.

Der Formierungsprozess ist technisch sowie chemisch komplex und umfasst typischerweise mehrere gleichzeitig ablaufende Reaktionen innerhalb der Batterie. Typischerweise wird nicht die gesamte, während der Formierung übertragene Ladung für die Ausbildung der SEl-Schicht verwendet. Das ist deshalb der Fall, da gleichzeitig reguläre Lade- und Entladeprozesse erfolgen, bei denen Lithium-Ionen in die Elektroden ein- und ausgelagert werden. Diese Komplexität erfordert sorgfältig eingestellte Strom-, Spannungs- und Temperaturprofile, damit die genannten parallelen Prozesse berücksichtigt werden.

Bekannte Formierungsverfahren beziehungsweise Formierungsprotokolle berücksichtigen typischerweise nicht die zellspezifischen Eigenschaften jeder elektrochemischen Batteriezelle. Diese Eigenschaften können aufgrund von Schwankungen im Produktionsprozess variieren und möglicherweise die Qualität der gebildeten SEI-Schicht beeinflussen. Somit besteht ein wachsender Bedarf an adaptiveren und effizienteren Formierungsprozessen, die Zelle-zu-Zelle-Variationen berücksichtigen und die Formierung für jede einzelne Batterie optimieren können.

Der vorliegenden Erfindung liegt die Aufgabe zugrunde, eine verbesserte Formierung für Batteriezellen bereitzustellen, die insbesondere individuelle Zelleigenschaften und Zellvariationen berücksichtigen kann.

Die Aufgabe wird durch ein Verfahren mit den Merkmalen des unabhängigen Patentanspruches 1, durch ein Herstellungsverfahren mit den Merkmalen des unabhängigen Anspruchs 10 sowie durch eine Vorrichtung mit den Merkmalen des unabhängigen Anspruchs 13 gelöst. In den abhängigen Patentansprüchen sind vorteilhafte Ausgestaltungen und Weiterbildungen der Erfindung angegeben.

Das erfindungsgemäße Verfahren zur Formierung einer Batteriezelle, insbesondere einer Batterie, wobei die Batteriezelle während eines Formierungsprozesses für wenigstens einen Zeitbereich mit einer eingestellten Stromstärke beaufschlagt wird, ist wenigstens durch folgende Schritte gekennzeichnet:
- Erfassen eines frequenzabhängigen Impedanzspektrums Z(w) der Batteriezelle vor oder während des Formierungsprozesses; und
- Einstellen der Stromstärke in Abhängigkeit von dem erfassten Impedanzspektrum Z(w).

Ein Batteriezelle beziehungsweise Zelle kann eine elektrochemische Einheit sein, die typischerweise mehrere Elektroden, Elektrolyt und Separatoren umfasst und elektrische Energie durch chemische Reaktionen speichern und abgeben kann. Insbesondere ist die Batteriezelle als Lithium-Ionen-Batteriezelle, Nickel-Metallhydrid-Batteriezelle und/oder Blei-Säure-Batteriezelle ausgebildet. Das erfindungsgemäße Verfahren kann für eine Batteriezelle oder für eine Batterie, die mehrere Batteriezellen umfasst, durchgeführt werden.

Ein Formierungsprozess ist eine Phase in der Batterieherstellung, bei der die Batteriezelle anfängliche Lade- und Entladezyklen durchläuft. Dieser Prozess ist wesentlich für die Bildung der Solid Electrolyte Interphase (SEI-Schicht) und die Aktivierung der elektrochemischen Komponenten der Zelle. Der Formierungsprozess beeinflusst maßgeblich die langfristige Leistung, Kapazität und Lebensdauer der Batterie.

Ein Impedanzspektrum Z(w) bezieht sich auf eine frequenzabhängige komplexwertige elektrische Impedanz einer Batteriezelle. Das Impedanzspektrum beziehungsweise die Impedanz ist somit für jede Frequenz eine komplexe Zahl, die typischerweise einen Realteil und einen Imaginärteil aufweist. In analogerweise könnte ein Betrag und eine Phase verwendet werden. Vorliegend bezeichnet ω die Frequenz beziehungsweise Kreisfrequenz. In analogerweise kann die Frequenz f in Hertz (Hz) mit ω = 2πf verwenden werden. Somit sind vorliegend Z(w) und Z(f) sowie w und f äquivalent.

Das Impedanzspektrum beziehungsweise die Impedanz wird bevorzugt mittels einer elektrochemischen Impedanzspektroskopie (EIS) ermittelt. Das Impedanzspektrum liefert Informationen über mehrere elektrochemische Prozesse innerhalb der Batteriezelle, beispielsweise über Ladungsübertragungskinetik, Diffusion und über Eigenschaften der SEI-Schicht.

Eine elektrochemische Impedanzspektroskopie (EIS) ist ein zerstörungsfreies Analyseverfahren, welches zur Charakterisierung der elektrischen Eigenschaften elektrochemischer Systeme verwendet wird. Im Kontext von Batteriezellen umfasst EIS das Anlegen eines Wechselstroms und/oder eines Spannungssignals über einen bestimmten Frequenzbereich sowie die anschließende Messung der Zellenreaktion. Das resultierende Impedanzspektrum ist somit frequenzabhängig und kann Informationen über die interne Struktur der Zelle, elektrochemische Prozesse und den Gesundheitszustand liefern.

Das erfindungsgemäße Verfahren weist wenigstens einen oder mehrere der folgenden Vorteile auf.

Individualisierter Formierungsprozess: Durch das Erfassen des frequenzabhängigen Impedanzspektrums Z(w) jeder Batteriezelle vor oder während des Formierungsprozesses ermöglicht das Verfahren einen maßgeschneiderten Ansatz zur Zellenformierung. Dies steht im Gegensatz zu bekannten Methoden, die ein standardisiertes Formierungsprotokoll auf alle Zellen anwenden, unabhängig von ihren individuellen elektrochemischen Eigenschaften. Das erfindungsgemäße Einstellen der Stromstärke in Abhängigkeit des erfassten Impedanzspektrums, insbesondere vor oder am Beginn des Formierungsprozesses, ermöglicht eine zellspezifische Optimierung des Formierungsprozesses, insbesondere unter einer Berücksichtigung von Variationen in Materialeigenschaften, Fertigungstoleranzen und/oder Zelle-zu-Zelle-Variationen.

Verbesserte Formierungseffizienz: Die adaptive Natur des Verfahrens, bei dem die Stromstärke basierend auf dem Impedanzspektrum eingestellt wird, ermöglicht eine effizientere Energienutzung während des Formierungsprozesses. Durch die Einstellung der Stromstärke an die spezifischen Eigenschaften jeder Zelle über das zellspezifische Impedanzspektrum kann das Verfahren den Gesamtenergieverbrauch und die für die Formierung erforderliche Zeit reduzieren. Dies ist besonders vorteilhaft, da der Formierungsprozess einer der energieintensivsten und zeitaufwändigsten Schritte in der Batterieproduktion ist.

Verbesserte Qualitätskontrolle: Die Impedanzmessung liefert wertvolle Informationen über die interne Struktur und elektrochemischen Eigenschaften der Zelle, insbesondere bevor der eigentliche Formierungsprozess, bei welchem die Batteriezelle mit der Stromstärke beaufschlagt wird, beginnt. Dies ermöglicht eine frühzeitige Erkennung potenzieller Defekte und/oder Anomalien in der Zelle, die durch andere Qualitätskontrollmaßnahmen möglicherweise nicht erkennbar sind. Zellen, die Impedanzspektren außerhalb der erwarteten Bereiche aufweisen, können identifiziert und möglicherweise vor dem ressourcenintensiven Formierungsprozess aus der Produktionslinie aussortiert werden, wodurch Zeit und Energie eingespart werden können.

Optimierte SEI-Bildung: Die Feststoff-Elektrolyt-Grenzphase (SEI-Schicht), die sich während der ersten Lade- und Entladezyklen des Formierungsprozesses ausbildet, ist entscheidend für eine langfristige Leistung und Stabilität der Batteriezelle. Durch die Einstellung der Stromstärke basierend auf dem Impedanzspektrum ermöglicht das Verfahren eine präzisere Kontrolle über die Bedingungen, unter denen sich die SEI-Schicht bildet. Dies kann zur Entwicklung einer stabileren und gleichmäßigeren SEI-Schicht führen, was potenziell die Kapazitätserhaltung, Lebensdauer und Gesamtleistung der Zelle verbessert.

Anpassungsfähigkeit an verschiedene Zellchemien: Die Abhängigkeit des Verfahrens von der Impedanz der Batteriezelle macht es anpassungsfähig an verschiedene Batteriechemien und - designs. Im Gegensatz zu einigen Formierungstechniken, die möglicherweise spezifisch für ermittelte Zelltypen sind, kann das Verfahren für eine Vielzahl von Batterietechnologien verwendet werden, einschließlich, jedoch nicht beschränkt auf Lithium-Ionen-, Nickel-Metallhydrid- und Blei-Säure-Zellen.

Echtzeitprozessüberwachung: Durch die Einbeziehung von Impedanzmessungen in den Formierungsprozess bietet das Verfahren eine Möglichkeit zur Echtzeitüberwachung der elektrochemischen Eigenschaften der Zelle. Dies ermöglicht potenzielle Anpassungen während des Formierungsprozesses selbst, anstatt sich ausschließlich auf Tests nach der Formierung zu verlassen, um die Zellqualität zu beurteilen.

Reduzierte Produktionskosten: Die synergetische Kombination aus verbesserter Formierungseffizienz, erweiterter Qualitätskontrolle und optimierter SEI-Bildung kann die Gesamtproduktionskosten reduzieren. Durch die Minimierung des Energieverbrauchs, die Reduzierung der Anzahl defekter Zellen, die eine vollständige Formierung durchlaufen, und die Verbesserung der langfristigen Leistung der Zellen kann das Verfahren zu kosteneffektiveren Batterieherstellungsprozessen beitragen.

Rückmeldung für vorgelagerte Prozesse: Die vor oder während der Formierung gesammelten Impedanzdaten können wertvolle Einblicke in die Effektivität vorgelagerter Fertigungsprozesse beziehungsweise Herstellungsprozesse bereitstellen. Variationen in Impedanzspektren über eine Charge von Zellen hinweg können auf Probleme bei der Elektrodenbeschichtung, Elektrolytbefüllung und/oder weiteren Produktionsschritten hinweisen. Dieser Rückkopplungsmechanismus ermöglicht eine kontinuierliche Verbesserung des gesamten Herstellungsprozesses, nicht nur der Formierungsphase.

Verbesserte Batterieleistung: Durch die Optimierung des Formierungsprozesses für jede einzelne Zelle verbessert das Verfahren die gesamten Leistungsmerkmale der produzierten Batterien. Dies umfasst die Möglichkeit einer erhöhten Kapazität, einer verbesserten Lebensdauer und/oder einer konsistenteren Leistung über eine Charge von Zellen hinweg.

Zusammenfassend wird durch das erfindungsgemäße Verfahren eine verbesserte und effizientere Batterieherstellung ermöglicht, die zu qualitativ verbesserten und zu leistungsfähigeren Batteriezellen für ein breites Spektrum von Anwendungen führt.

Das erfindungsgemäße Herstellungsverfahren zur Herstellung wenigstens einer Batteriezelle, bei dem eine Formierung der Batteriezelle durchgeführt wird, ist dadurch gekennzeichnet, dass die Formierung der Batteriezelle gemäß einem der vorhergehenden Ansprüche durchgeführt wird.

Es ergeben sich zum erfindungsgemäßen Verfahren gleichartige, gleichwertige und gleichwirkende Vorteile.

Die erfindungsgemäße Vorrichtung zur Formierung einer Batteriezelle, umfassend eine Messeinheit und eine Stromeinheit, wobei die Stromeinheit dazu ausgebildet ist, während eines Formierungsprozesses für wenigstens einen Zeitbereich die Batteriezelle mit einer einstellbaren Stromstärke zu beaufschlagen, ist dadurch gekennzeichnet, dass:
- die Messeinheit dazu ausgebildet ist, ein frequenzabhängiges Impedanzspektrum Z(w) der Batteriezelle vor oder während des Formierungsprozesses zu erfassen; und
- die Stromstärkeeinheit dazu ausgebildet ist, die Stromstärke in Abhängigkeit vom erfassten Impedanzspektrum Z(w) einzustellen.

Es ergeben sich zum erfindungsgemäßen Verfahren gleichartige, gleichwertige und gleichwirkende Vorteile.

Gemäß einer bevorzugten Ausgestaltung der Erfindung wird mittels des erfassten Impedanzspektrums eine Kapazität C ermittelt, wobei die Stromstärke proportional zu der ermittelten Kapazität C eingestellt wird.

Dadurch wird eine besonders effektive Methode zur Optimierung des Formierungsprozesses basierend auf den individuellen Eigenschaften der Zelle bereitgestellt. Die Kapazität C steht in direktem Zusammenhang mit der elektrochemisch aktiven Oberfläche der Elektroden, die entscheidend für die Ausbildung der SEI-Schicht ist. Durch das proportionale Einstellen der Stromstärke zur ermittelten Kapazität wird vorteilhafterweise sichergestellt, dass die Stromdichte an der Elektrodenoberfläche über Zellen mit unterschiedlichen aktiven Oberflächen hinweg im Wesentlichen konstant bleibt. Dadurch wird eine gleichmäßigere SEI-Bildung erreicht und die Gesamtqualität und Konsistenz der produzierten Zellen verbessert. Die ermittelte Kapazität ist im Wesentlichen frequenzunabhängig, da diese gesamtheitlich aus dem Impedanzspektrum, beispielsweise mittels eines Ersatzschaltbildes und/oder mittels des Imaginärteils der Impedanz, ermittelt wird.

Gemäß einer bevorzugten Ausgestaltung der Erfindung wird die Kapazität C mittels eines Ersatzschaltbildmodells für das Impedanzspektrum Z(w) ermittelt.

Die Verwendung eines Ersatzschaltbildmodells zur Bestimmung beziehungsweise Ermittlung der Kapazität ist besonders vorteilhaft. Insbesondere wird dadurch eine Trennung verschiedener elektrochemischer Prozesse, die zur Gesamtimpedanz beitragen, wie beispielsweise Ladungsübertragungsreaktionen, Doppelschichtkapazitäten und Diffusionsprozesse, ermöglicht. Durch die Ermittlung der kapazitiven Elemente im Modell kann eine verbesserte Abschätzung der Elektrodenoberfläche bereitgestellt werden, wodurch eine verbesserte Einstellung der Stromstärke ermöglicht wird.

Gemäß einer bevorzugten Ausgestaltung der Erfindung wird die Kapazität durch C = -1/[ω·lm Z(w)] ermittelt.

Dadurch wird die Kapazität besonders vorteilhaft unmittelbar aus dem Imaginärteil (Im Z) des Impedanzspektrums ermittelt. Die Kapazität wird somit schnell und rechnerisch effizient, insbesondere ohne komplexe Modellierung, ermittelt. Die Gleichung C = - 1/[ω·lm Z(w)] ist besonders effektiv, wenn das Impedanzspektrum im erfassten und verwendeten Frequenzbereich von einem kapazitiven Verhalten dominiert wird. Dies ist insbesondere für vor und/oder zu Beginn des eigentlichen Formierungsprozesses der Fall. Äquivalent kann C = - 1/[2πf·lm Z(f)] verwendet werden.

Gemäß einer bevorzugten Ausgestaltung der Erfindung wird das Impedanzspektrum Z(w) zu Beginn des Formierungsprozesses erfasst.

Die Erfassung des Impedanzspektrums zu Beginn des Formierungsprozesses ermöglicht eine sofortige Anpassung der Formierungsparameter basierend auf dem Anfangszustand der Zelle. Dieser Zeitpunkt ist entscheidend, da er Informationen über die Eigenschaften der Zelle liefert, bevor signifikante Veränderungen durch den Formierungsprozess selbst auftreten. Dadurch kann die Methode Variationen in den Zelleneigenschaften berücksichtigen, die möglicherweise während vorheriger Fertigungsschritte, wie beispielsweise der Elektrodenbeschichtung oder Elektrolytbefüllung, entstanden sind. Der Beginn des Formierungsprozesses kann durch die ersten Minuten des Formierungsprozesses gekennzeichnet sein.

Gemäß einer bevorzugten Ausgestaltung der Erfindung wird das Impedanzspektrum Z(w) von 1 Hz bis 1 kHz erfasst.

Mit anderen Worten erstreckt sich das erfasste Impedanzspektrum und seine erfassten beziehungsweise gemessenen Werte über den genannten Frequenzbereich. Hierbei kann das Impedanzspektrum im genannten Frequenzbereich diskret durch einzelne Messwerte und/oder kontinuierlich, beispielsweise durch einen Fit, vorliegen. Der genannte Frequenzbereich ist besonders gut geeignet, um die für die Batteriezellenformierung relevanten elektrochemischen Prozesse zu charakterisieren. Die untere Frequenzgrenze von 1 Hz ermöglicht die Erfassung langsamerer Prozesse, wie beispielsweise Diffusion, während die obere Grenze von 1 kHz schnellere Prozesse, wie beispielsweise Ladungsübertragungsreaktionen und Elektrolytwiderstand, erfasst. Somit wird ein umfassender Überblick über das elektrochemische Verhalten der Zelle, ohne sich auf extrem niedrige Frequenzen auszudehnen, die die Messzeit erheblich verlängern würden, bereitgestellt.

Gemäß einer bevorzugten Ausgestaltung der Erfindung wird das Impedanzspektrum Z(w) von 10 Hz bis 100 Hz erfasst.

Dieser engere Frequenzbereich konzentriert sich auf die relevantesten Frequenzen zur Charakterisierung der Doppelschichtkapazität und Ladungsübertragungsprozesse in der Zelle. Insbesondere kann dadurch die Kapazität, das heißt der kapazitive Einfluss innerhalb des Impedanzspektrums, verbessert ermittelt werden. Durch die vorteilhafte Beschränkung der Messung auf den genannten Frequenzbereich kann die Methode die erforderlichen Informationen für die Einstellung der Stromstärke erhalten und gleichzeitig die für die Impedanzmessung erforderliche Zeit minimieren. Dies ist besonders vorteilhaft in einer Produktionsumgebung, in der ein schneller Durchsatz wesentlich ist.

Gemäß einer bevorzugten Ausgestaltung der Erfindung wird das Impedanzspektrum Z(ω) mittels einer elektrochemischen Impedanzspektroskopie erfasst.

Die elektrochemische Impedanzspektroskopie (EIS) ist eine leistungsfähige und etablierte Messmethode zur Charakterisierung elektrochemischer Systeme. Sie bietet hohe Empfindlichkeit und die Fähigkeit, zwischen verschiedenen Prozessen innerhalb der Zelle zu unterscheiden. Durch die Verwendung von EIS kann die Methode detaillierte Informationen über die interne Struktur und elektrochemischen Eigenschaften der Zelle erhalten, was eine präzisere Einstellung der Stromstärke ermöglicht.

Gemäß einer bevorzugten Ausgestaltung der Erfindung wird das Impedanzspektrum Z(ω) vor dem Formierungsprozess erfasst, und die Batteriezelle wird aussortiert, wenn das Impedanzspektrum Z(w) festgelegte Referenzbereiche verletzt.

Dadurch wird ein besonders vorteilhafter Qualitätskontrollschritt vor dem energieintensiven Formierungsprozess durchgeführt. Durch den Vergleich des gemessenen Impedanzspektrums mit festgelegten Referenzbereichen können Zellen identifiziert werden, die von den erwarteten und somit gewünschten Eigenschaften abweichen. Dies ermöglicht die frühzeitige Erkennung und Entfernung potenziell defekter Zellen und verhindert die Verschwendung von Ressourcen für Zellen, die nach der Formierung nicht die Qualitätsstandards erfüllen werden. Die Referenzbereiche können durch jeweilige Bereiche für den Realteil und den Imaginärteil der Impedanz ausgebildet werden. Ebenfalls ist ein komplex geformter beziehungsweise ausgebildeter Referenzbereich, der sich um ein Referenzimpedanzspektrum erstreckt, denkbar.

Gemäß einer bevorzugten Ausgestaltung der Erfindung werden ein oder mehrere Herstellungsprozesse der Batteriezelle vor der Formierung in Abhängigkeit vom erfassten Impedanzspektrum Z(w) eingestellt.

Dadurch werden die Vorteile der Impedanzmessung über den Formierungsprozess hinaus verwendet. Dies stellt eine Rückkopplungsschleife für die kontinuierliche Verbesserung des gesamten Herstellungsprozesses bereit. Durch die Analyse der Impedanzspektren der produzierten Zellen können vorteilhafte Anpassungen an vorgelagerten Prozessen, wie beispielsweise einer Elektrodenbeschichtung, einer Kalandrierung und/oder einer Elektrolytbefüllung vorgenommen werden. Dadurch kann eine konsistentere Zellenqualität erreicht werden und zudem die Anzahl der Zellen reduziert werden, die aufgrund von außerhalb des Referenzbereichs liegenden Impedanzspektren aussortiert werden müssen.

Gemäß einer bevorzugten Ausgestaltung der Erfindung werden eine Elektrolytbefüllung, eine Lagerzeit, eine Elektrodenbeschichtung, ein Kalandrierprozess und/oder ein Trocknungsprozess in Abhängigkeit von dem erfassten Impedanzspektrum eingestellt.

Diese Ausführungsform bietet spezifische Beispiele für vorgelagerte Prozesse, die basierend auf den Impedanzdaten in vorteilhafterweise optimiert werden können. Jeder dieser Prozesse kann die elektrochemischen Eigenschaften der Zelle und folglich ihr Impedanzspektrum beeinflussen. Beispielsweise könnten Variationen in den Impedanzdaten auf Probleme mit der Elektrolytbenetzung hinweisen und Anpassungen des Befüllungsprozesses und/oder der Lagerungszeit nahelegen. Weiterhin könnten unerwartete Änderungen im kapazitiven Verhalten auf Unregelmäßigkeiten in den Elektrodenbeschichtungs- oder Kalandrierprozessen hindeuten.

Weitere Vorteile, Merkmale und Einzelheiten der Erfindung ergeben sich aus den im Folgenden beschriebenen Ausführungsbeispielen sowie anhand der Zeichnungen. Dabei zeigen schematisiert:
- Figur 1: ein Flussdiagramm des Verfahrens zur Formierung einer Batteriezelle; und
- Figur 2: Impedanzspektren einer Batteriezelle vor und nach ihrem Formierungsprozess.

Gleichartige, gleichwertige oder gleichwirkende Elemente können in einer der Figuren oder in den Figuren mit denselben Bezugszeichen versehen sein.

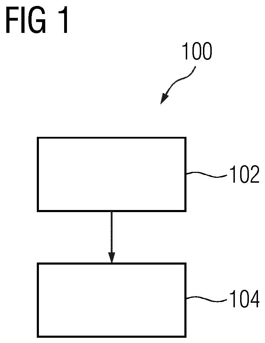

Die Figur 1 zeigt ein Flussdiagramm eines Verfahrens 100 zur Formierung einer Batteriezelle. Das dargestellte Verfahren 100 umfasst wenigstens zwei Schritte 102, 104. Die Formierung umfasst wenigstens einen Formierungsprozess, innerhalb welchen die Batteriezelle mit einer Stromstärke, typischerweise über mehrere Lade- und Entladezyklen hinweg, beaufschlagt wird.

Im Schritt 102 wird ein frequenzabhängiges Impedanzspektrum Z(w) der Batteriezelle erfasst oder gemessen. Diese Messung wird entweder vor Beginn des eigentlichen Formierungsprozesses der Formierung oder während seiner Anfangsphase durchgeführt. Hierbei sollte der Formierungsprozess bevorzugt noch nicht so weit fortgeschritten sein, dass bereits ein merklicher Aufbau und/oder Änderung der SEI-Schicht vorliegt.

Das Impedanzspektrum liefert vorteilhafte Informationen über die elektrochemischen Eigenschaften der Zelle, einschließlich ihres inneren Widerstands, ihrer Kapazität und ihrer Ladungsübertragungscharakteristiken. Insbesondere können die genannten Größen mittels eines Ersatzschaltbildmodells, welches das erfasste Impedanzspektrum modelliert, ermittelt werden.

Die Impedanzmessung kann mittels einer elektrochemischen Impedanzspektroskopie (EIS) durchgeführt werden. Hierbei wird ein kleines Wechselstromsignal und/oder Spannungssignal über einen festgelegten Frequenzbereich an die Zelle angelegt. Der Frequenzbereich für die genannte Messung liegt bevorzugt zwischen 1 Hz und 1 kHz, besonders bevorzugt zwischen 10 Hz bis 100 Hz. Dadurch können die bezüglich der SEI-Schicht relevantesten elektrochemischen Prozesse erfasst werden. Alternativ oder ergänzend könnten Pulsmesstechniken und/oder Einzelfrequenzmessungen verwendet werden.

Der Schritt 104 umfasst das Einstellen der Stromstärke für den eigentlichen Formierungsprozess, basierend auf dem erfassten Impedanzspektrum Z(w). Dadurch wird der Formierungsprozess in seiner Stromstärke und somit in der Ausbildung der SEI-Schicht zellspezifisch eingestellt. Das ist deshalb der Fall, da dies basierend auf dem zellspezifischen erfassten Impedanzspektrum erfolgt. Es wird somit im Gegensatz zu bekannten Verfahren kein für alle Batteriezellen festgelegtes Formierungsprotokoll verwendet.

Das Einstellen der Stromstärke kann auf mehrere Weise basierend auf den Impedanzdaten erfolgen. Ein besonders vorteilhafter Ansatz besteht darin, die (Ersatz-)Kapazität C aus dem Impedanzspektrum zu ermitteln und die Stromstärke proportional zu der ermittelten Kapazität einzustellen. Dies kann gemäß der Gleichung C = - 1/[ω·lm Z(w)] erfolgen, wobei Im Z(w) den Imaginärteil der frequenzabhängigen Impedanz beziehungsweise des erfassten Impedanzspektrums bezeichnet.

Obwohl nicht explizit dargestellt, könnte das Verfahren eine zeitlich wiederholende Neuvermessung des Impedanzspektrums während des Formierungsprozesses umfassen, was eine Echtzeitoptimierung der Stromstärke während des Formierungsprozesses ermöglicht.

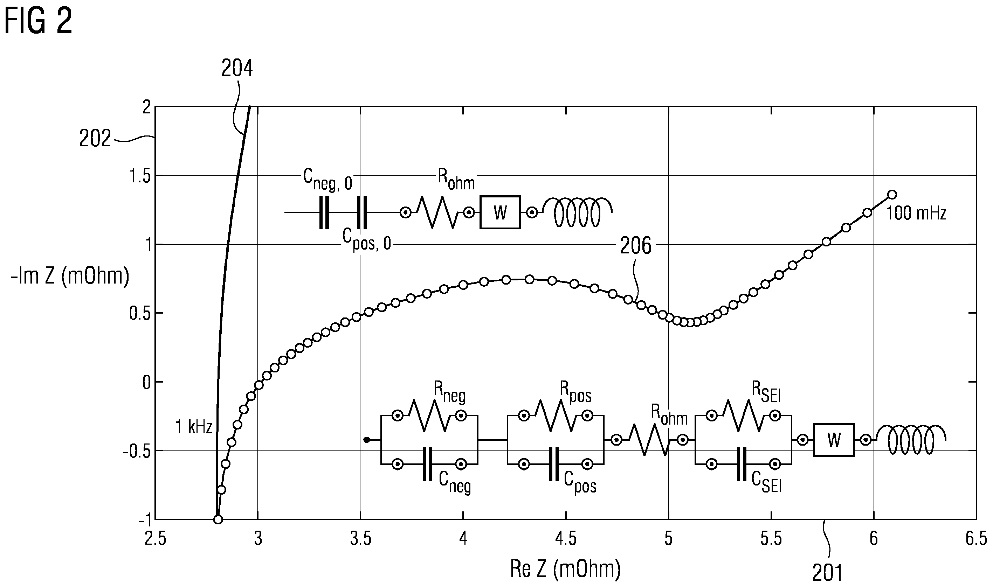

Die Figur 2 zeigt beispielhafte Impedanzspektren einer Batteriezelle vor und nach ihrem Formierungsprozess.

An der Abszisse 201 ist der Realteil der Impedanz (Re Z) des jeweiligen Impedanzspektrums in Milliohm aufgetragen.

An der Ordinate 202 ist der Imaginärteil der Impedanz (Re Z) des jeweiligen Impedanzspektrums in Milliohm aufgetragen.

Das Impedanzspektrum vor dem Formierungsprozess ist mit dem Bezugszeichen 204 gekennzeichnet. Das Impedanzspektrum nach dem Formierungsprozess ist mit dem Bezugszeichen 206 gekennzeichnet. Die Frequenzen erstrecken sich von hohen Frequenzen, beispielsweise 1 kHz auf der linken Seite der Kurve zu niedrigen Frequenzen, beispielsweise 1 Hz oder niedriger auf der rechten Seite der Kurve.

Das Impedanzspektrum 204 vor der Formierung ist durch eine steile, nahezu vertikale Linie gekennzeichnet. Diese Form ist typisch für eine Zelle, die ein dominantes kapazitives Verhalten aufweist, welches hauptsächlich aufgrund der Doppelschichtkapazität an der Feststoff-Elektrolyt-Grenzphase auftritt. Der Hochfrequenz-Schnittpunkt dieser Linie mit der x-Achse liefert eine Abschätzung des ohmschen Widerstands der Zelle.

Im Gegensatz dazu zeigt das Impedanzspektrum 206 nach der Formierung eine komplexere Form mit mehreren Merkmalen. Diese umfassen typischerweise einen Hochfrequenz-Schnittpunkt, der dem ohmschen Widerstand der Zelle entspricht, einen oder mehrere halbkreisförmige Bögen im mittleren Frequenzbereich, die oft mit Ladungsübertragungsprozessen und mit der Bildung der Feststoff-Elektrolyt-Grenzphase assoziiert sind sowie einen niederfrequenten Ausläufer, der mit Diffusionsprozessen innerhalb der Elektroden zusammenhängen kann. Die Unterschiede zwischen den Spektren 204, 206 vor und nach der Formierung verdeutlichen die signifikanten Veränderungen, die während des Formierungsprozesses auftreten. Diese Veränderungen können eine Ausbildung der SEI-Schicht, die für die langfristige Stabilität und Leistung der Batterie entscheidend ist, sowie Änderungen der Eigenschaften der SEI-Schicht, die sich in dem veränderten kapazitiven Verhalten widerspiegeln kann, umfassen. Weiterhin können Modifikationen der Ladungsübertragungskinetik, typischerweise sichtbar in den halbkreisförmigen Merkmalen des Spektrums nach der Formierung, erkannt werden.

Durch die Analyse der Impedanzspektren 204, 206 können wertvolle Informationen über den Zustand der Zelle und die Effektivität des Formierungsprozesses gewonnen werden. Zum Beispiel können die Größe und Form der halbkreisförmigen Merkmale im Spektrum nach der Formierung auf die Qualität der SEl-Schichtbildung hinweisen. Das Niederfrequenzverhalten kann Einblicke in die Diffusionseigenschaften innerhalb der Elektroden liefern, die für die Ratenfähigkeit der Zelle entscheidend sind. Weiterhin kann der Vergleich der Spektren 204, 206 vor und nach der Formierung der Beurteilung des gesamten Formierungsprozesses dienen. Signifikante Abweichungen von erwarteten Mustern könnten auf Probleme mit der Zelle und/oder dem Formierungsverfahren hinweisen und eine frühzeitige Erkennung potenzieller Probleme bei der Herstellung ermöglichen.

Obwohl die Erfindung im Detail durch die bevorzugten Ausführungsbeispiele näher illustriert und beschrieben wurde, so ist die Erfindung nicht durch die offenbarten Beispiele eingeschränkt oder andere Variationen können vom Fachmann hieraus abgeleitet werden, ohne den Schutzumfang der Erfindung zu verlassen.

### Bezugszeichenliste

- 100: Verfahren
- 102: Schritt
- 104: Schritt
- 201: Abszisse
- 202: Ordinate
- 204: Impedanzspektrum vor einem Formierungsprozess
- 206: Impedanzspektrum nach einem Formierungsprozess

## Patentansprüche

1. Verfahren (100) zur Formierung einer Batteriezelle, wobei die Batteriezelle während eines Formierungsprozesses für wenigstens einen Zeitbereich mit einer eingestellten Stromstärke beaufschlagt wird, **gekennzeichnet durch** die folgenden Schritte:
- (102) Erfassen eines frequenzabhängigen Impedanzspektrums Z(w) der Batteriezelle vor oder während des Formierungsprozesses; und
- (104) Einstellen der Stromstärke in Abhängigkeit vom erfassten Impedanzspektrum Z(w).

2. Verfahren (100) gemäß Anspruch 1, **dadurch gekennzeichnet, dass** mittels des aufgezeichneten Impedanzspektrums eine Kapazität C ermittelt wird, wobei die Stromstärke proportional zu der ermittelten Kapazität C eingestellt wird.

3. Verfahren (100) gemäß Anspruch 2, **dadurch gekennzeichnet, dass** die Kapazität C mittels eines Ersatzschaltbildmodells für das Impedanzspektrum Z(ω) ermittelt wird.

4. Verfahren (100) gemäß Anspruch 2 oder 3, **dadurch gekennzeichnet, dass** die Kapazität durch C = -1/[ω·lm Z(w)] ermittelt wird.

5. Verfahren (100) gemäß einem der vorhergehenden Ansprüche, **dadurch gekennzeichnet, dass** das Impedanzspektrum Z(w) zu Beginn des Formierungsprozesses erfasst wird.

6. Verfahren (100) gemäß einem der vorhergehenden Ansprüche, **dadurch gekennzeichnet, dass** das Impedanzspektrum Z(w) von 1 Hz bis 1 kHz erfasst wird.

7. Verfahren (100) gemäß einem der vorhergehenden Ansprüche, **dadurch gekennzeichnet, dass** das Impedanzspektrum Z(w) von 10 Hz bis 100 Hz erfasst wird.

8. Verfahren (100) gemäß einem der vorhergehenden Ansprüche, **dadurch gekennzeichnet, dass** das Impedanzspektrum Z(ω) mittels einer elektrochemischen Impedanzspektroskopie erfasst wird.

9. Verfahren (100) gemäß einem der vorhergehenden Ansprüche, **dadurch gekennzeichnet, dass** das Impedanzspektrum Z(ω) vor dem Formierungsprozess erfasst wird, und die Batteriezelle aussortiert wird, wenn das Impedanzspektrum Z(w) festgelegte Referenzbereiche verletzt.

10. Herstellungsverfahren für wenigstens eine Batteriezelle, bei dem eine Formierung der Batteriezelle durchgeführt wird, **dadurch gekennzeichnet, dass** die Formierung der Batteriezelle gemäß einem der vorhergehenden Ansprüche erfolgt.

11. Herstellungsverfahren gemäß Anspruch 10, **dadurch gekennzeichnet, dass** ein oder mehrere der Formierung vorgelagerte Herstellungsprozesse der Batteriezelle in Abhängigkeit vom erfassten Impedanzspektrum Z(w) eingestellt werden.

12. Herstellungsverfahren gemäß Anspruch 10 oder 11, **dadurch gekennzeichnet, dass** eine Elektrolytbefüllung, eine Lagerzeit, eine Elektrodenbeschichtung, ein Kalandrierprozess und/oder ein Trocknungsprozess in Abhängigkeit vom erfassten Impedanzspektrum eingestellt werden.

13. Vorrichtung zur Formierung einer Batteriezelle, umfassend eine Messeinheit und eine Stromeinheit, wobei die Stromeinheit dazu ausgelegt ist, während eines Formierungsprozesses für wenigstens einen Zeitbereich die Batteriezelle mit einer einstellbaren Stromstärke zu beaufschlagen, **dadurch gekennzeichnet, dass**:
- die Messeinheit dazu ausgebildet ist, ein frequenzabhängiges Impedanzspektrum Z(w) der Batteriezelle vor oder während des Formierungsprozesses zu erfassen; und
- die Stromstärkeeinheit dazu ausgebildet ist, die Stromstärke in Abhängigkeit vom erfassten Impedanzspektrum Z(w) einzustellen.
